# EUROPEAN PATENT APPLICATION

(11) **EP 4 678 313 A1**
(43) Date of publication of application: **14.01.2026**
(21) Application number: 24766685.2
(22) Date of filing: 19.01.2024
(51) Int. Cl.: B23B 27/14, B23B 51/00, B23C 5/16, B23P 15/28, C23C 16/32, C23C 16/36

(54) **COATED CUTTING TOOL**

(30) Priority: 06.03.2023 JP 2023033460; 25.10.2023 JP 2023183584
(71) Applicant: MOLDINO Tool Engineering, Ltd., Tokyo 130-0026 (JP)
(72) Inventor: IMAI Masayuki, Narita-shi, Chiba 286-0825 (JP)
(74) Representative: Gille Hrabal Partnerschaftsgesellschaft mbB Patentanwälte
(86) International application number: PCT/JP2024/001448
(87) International publication number: WO 2024/185310

(57) **Abstract**

Provided is a coated cutting tool comprising a base material and a coating layer on a surface of the base material, wherein: the coating layer is a chemical vapor deposition coating layer containing columnar grains of a composite nitride of Al and Cr or a composite carbonitride of Al and Cr; in a cross-section parallel to the surface of the base material, the columnar grains each have a plate-shaped region that extends across the columnar grain and regions that are opposite from each other with the plate-shaped region therebetween; the Al content in the plate-shaped region is less than the Al content in the regions that are opposite from each other with the plate-shaped region part therebetween; the average composition of the coating layer is AlₓCr₁₋ₓC_{y}N_{1-y} (where 0.50≤x≤0.95 and 0.0≤y≤0.4); the columnar grains include grains of a face-centered cubic lattice structure including a first layer and a second layer therein; the first layer and the second layer are laminated alternately; adjacent layers are in contact at a twin plane angle; and the Al content of the first layer is greater than the Al content of the second layer.

## Description

### Technical Field

The present invention relates to coated cutting tools. This application claims priority based on Japanese Patent Application Nos. 2023-033460 filed on March 6, 2023 and 2023-183584 filed on October 25, 2023. The entire description in the Japanese patent applications is hereby incorporated by reference.

### Background Art

Coated cutting tools with coating layers vapor-deposited on substrates made of, for example, tungsten carbide (hereinafter referred to as "WC") have been used. These coated cutting tools exhibit enhanced durability. In order to further enhance the durability of these coated cutting tools, various proposals have been made concerning the composition and configuration of the coating layers.

For example, Patent Literature 1 discloses a coated cutting tool with a coating layer formed by chemical vapor deposition of AlCr composite nitride with fine columnar crystal grains (columnar structure). This coated cutting tool has high durability.

### Citation List

### Patent Literature

PTL 1: WO2019/098130

### Summary of Invention

### Technical Problem

An object of the present invention, which was made in view of the aforementioned circumstances and proposal, is to provide a coated cutting tool that is provided with coating layer formed by chemical vapor deposition of AlCr composite nitride or composite carbonitride and has high durability.

### Solution to Problem

A coated cutting tool in accordance with embodiments of the present invention comprises:
a substrate and a coating layer on a surface of the substrate, wherein
the coating layer comprises columnar crystal grains of composite nitride or carbonitride of aluminum and chromium made by chemical vapor deposition;
the columnar crystal grains have a plate-shaped region extending through the columnar crystal grains and opposing regions on two sides of the plate-shaped region, in a cross-section parallel to the surface of the substrate, and
the plate-shaped region has an aluminum content less than the aluminum content of the opposing regions on the two sides of the plate-shaped region.

The coated cutting tool in accordance with the embodiments may satisfy one or more of the following conditions (1) to (4):

(1) The difference in the aluminum content between the plate-shaped region and the opposing regions on the two sides of the plate-shaped region is at least 10 atom%.
(2) The aluminum content of the plate-shaped region is in a range of 30 to 80 atom% and the aluminum content of the opposing regions on the two sides of the plate-shaped region is in a range of 60 to 95 atom%.
(3) The columnar crystal grains have an fcc crystal structure both in the plate-shaped region and in the opposing regions opposite on the two sides of the plate-shaped region.
(4) The coating layer has an average composition represented by AlₓCr₁₋ₓC_{y}N_{1-y} where 0.50 ≤ x ≤ 0.95 and 0.0 ≤ y ≤ 0.4,
   the columnar crystal grains each comprise first layers and second layers therein and have a face-centered cubic lattice structure,
   the first layers and second layers are alternately stacked, and the first and second layers of one columnar crystal grain are in contact with the first and second layers of another columnar crystal grain at a specific angle via a twinned plane, and
   the first layers each have an aluminum content higher than that of the
   second layers.

### Advantageous Effects of Invention

The coated cutting tool described above exhibit high durability.

### Brief Description of Drawings

Fig. 1 is a photograph of a longitudinal section of a coating layer of a coated cutting tool of Example 1 observed with a transmission electron microscope at a magnification of 5,000.
Fig. 2 is a photograph after dithering of Fig. 1.
Fig. 3 is a photograph of the surface of the coated layer of the coated cutting tool of Example 1 observed with a scanning electron microscope at a magnification of 20,000.
Fig. 4 is a photograph after dithering of Fig. 3.
Fig. 5 is a STEM image at a magnification of 20,000 of a cross section, parallel to the surface of the substrate, of the coated layer of the coated cutting tool of Example 1.
Fig. 6 is a photograph after dithering of Fig. 5.
Fig. 7 is a line diagram of Fig. 5.
Fig. 8 is a STEM image at a magnification of 20,000 of a transverse section in the direction of deposition of the film near the surface of the coated layer of the coated cutting tool of Example 1.
Fig. 9 is a photograph after dithering of Fig. 8.
Fig. 10 is a STEM image at a magnification of 100,000 of columnar crystal grains with a twinned crystal interface in the longitudinal section of the coating layer of the coated cutting tool of Example 1.
Fig. 11 is a photograph after dithering of Fig. 10.
Fig. 12 is a line diagram of Fig. 10.
Fig. 13 is a dark-field STEM image at a magnification of 300,000 of the twinned crystal interface in the longitudinal section of the coating layer of the coated cutting tool of Example 1.
Fig. 14 is a photograph after dithering of Fig. 13.
Fig. 15 is a line diagram of Fig. 13.
Fig. 16 is a schematic diagram of the film deposition furnace depicted in Fig. 1A of Japanese Patent No. 6660608.

### Description of Embodiments

The inventor has investigated coating layers with high durability based on the following recognition:
(1) Unlike the coating layer by physical vapor deposition, the coating layer by chemical vapor deposition does not contain droplets, has high adhesion to the substrate, can be made thicker, and is more durable than the coating layer by physical vapor deposition of the same composition, under certain cutting conditions; and
(2) Since AlCr composite nitride or AlCr composite carbonitride (hereinafter collectively referred to as AlCrCN) has high heat resistance and wear resistance, the coated cutting tool having a coating layer produced by chemical vapor deposition has high durability.

The inventor has diligently examined the possibility of production of an AlCrCN layer with high durability without refining the columnar structure by chemical vapor deposition.

As a result, the inventor has made the following findings (a), (b) and (c):
(a) The coated cutting tool exhibits high durability in the case that AlCrCN columnar crystal grains constituting the coating layer have a plate-shaped region extending through columnar crystal grains and opposing regions residing on two sides of the plate-shaped region and the aluminum content in the plate-shaped region is less than that of the opposing regions on the two sides of plate-shaped region, in a cross-section parallel to the surface of the substrate;
(b) the coated cutting tool exhibits high durability in the case that an AlCrCN coating layer with a specific composition includes columnar crystal grains with a face-centered cubic structure, each grain comprises first layers and second layers having different aluminum contents and alternately stacked, and the first and second layers of one columnar crystal grain are in contact with the first and second layers of another columnar crystal grain at a specific angle via a twinned plane
(c) the coated cutting tool exhibits higher durability in the case that the conditions (a) and (b) hold at the same time.

The present invention has been accomplished based on this knowledge. The coated cutting tools of the embodiments of the invention will now be described in detail.

When a numerical range is expressed as "L to M" where L and M are both numerical values throughout the specification and in the claims, the range is synonymous with L to M. When units are stated only for the upper limit (M), the units for the upper limit (M) and lower limit (L) are the same.

### 1. Average composition of coating layer

The coating layer of the coated cutting tool of this embodiment may be an AlCrCN layer, and the average composition of the coating layer is preferably represented by the formula: AlₓCr₁₋ₓC_{y}N_{1-y} where 0.50 ≤ x ≤ 0.95 and 0.0 ≤ y ≤ 0.4, for the reason described below.

### (1) Aluminum content

Aluminum contributes to improve the heat resistance of the coating layer and lubricative protection of the cutting edge, thereby improving durability of the tool. To make this function sufficient, the aluminum content should be 50 atom% or more (x ≥ 0.50). An excessively high aluminum content, however, leads to formation of AIN with a brittle hexagonal close-packed (hcp) structure, resulting in a decrease in durability of the coated cutting tool. Accordingly the aluminum content should more preferably be less than 95 atom% (x ≤ 0.95).

On the aluminum content, the lower limit is more preferably 60 atom% (x = 0.60), most preferably 70 atom% (x = 0.70). In other words, the aluminum content is more preferably in a range of 50 to 95 atom%, even more preferably in a range of 60 to 95 atom%, most preferably in a range of 70 to 95 atom%.

### (1) Cr content

Cr contributes to lubrication and protection of the cutting edge and prevention of deposition on the work material on the coating layer. It is preferable that the Cr content be 5 atom% (1-x = 0.05) or more to ensure that this function is sufficient. An excessively high Cr content however causes the aluminum content to decrease and thus the heat resistance of the coating layer to decline. Thus, it is more preferable to set the upper limit of Cr content at 50 atom% (1-x = 0.50).

In addition, the upper limit of the Cr content is even more desirably 40 atom% (1-x = 0.40), most desirably 30 atom% (1-x = 0.30). In other words, the Cr content is more preferably in a range of 5 to 50 atom%, most preferably in a range of 5 to 40 atom%, most preferably in a range of 5 to 30 atom%.

### (3) C content and N content

C and N can solve the aforementioned problems if they are nitrides and carbonitrides in the case of 0.0 ≤ y ≤ 0.4, i.e., a C content of 0.0 to 0.4 and a N content of 0.6 to 1.0. More preferred is 0.0 ≤ y ≤ 0.3.

The deposition is preferably performed such that the ratio of the number of (AlCr) molecules to the number of (CN) molecules be 1:0.8 to 1:1.2.

### 2. Structure of coating layer

The structure of the AlCrCN layer of the coated cutting tool will now be described.

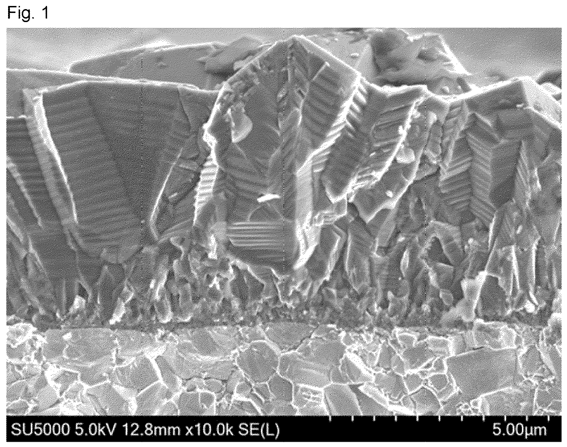

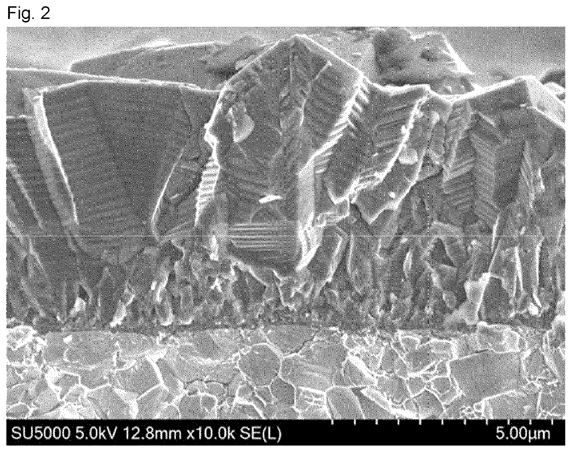

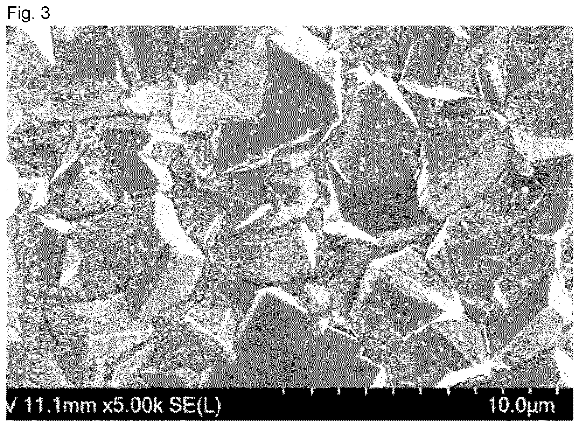

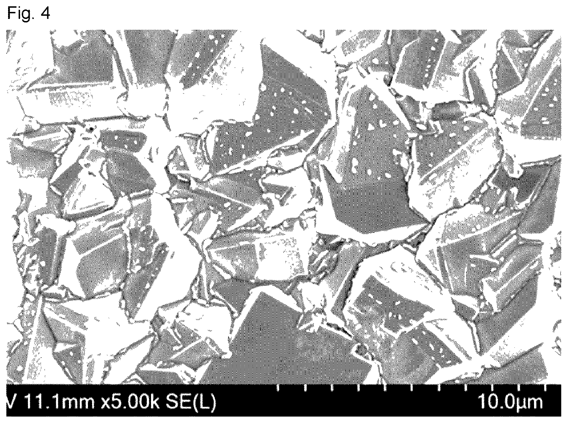

The structure of the AlCrCN layer of the coated cutting tool has columnar grains (columnar crystals) with a face-centered cubic structure. This is shown in Fig. 1, which is a photograph of a longitudinal section of the coated layer of the coated cutting tool (cross-section perpendicular to the surface of the substrate with the proviso that the surface of the substrate has no minute irregularities) observed with a transmission electron microscope at a magnification of 5,000, and Fig. 2, which is an image after dithering of Fig. 1, showing the cross-sectional structure in the direction of the growth of columnar grains. Furthermore, Fig. 3, which is a photograph of the surface of the coating layer of the coated cutting tool in Fig. 1 observed by scanning electron microscopy, and Fig. 4, which is a version after dithering of Fig. 3, show the structure of the top surface of the columnar grains.

### (1) Plate-shaped region extending between columnar crystal grains

Part of the columnar crystal grains includes a plate-shaped region that extends between the columnar crystal grains in a horizontal cross-section (the cross-section horizontal to the surface of the substrate with the proviso that no microscopic irregularities exist on the surface of the substrate) and an opposing regions on two sides of this plate-shaped region (hereinafter referred to as the "opposing regions"). The plate-shaped region contains less aluminum than the opposing regions.

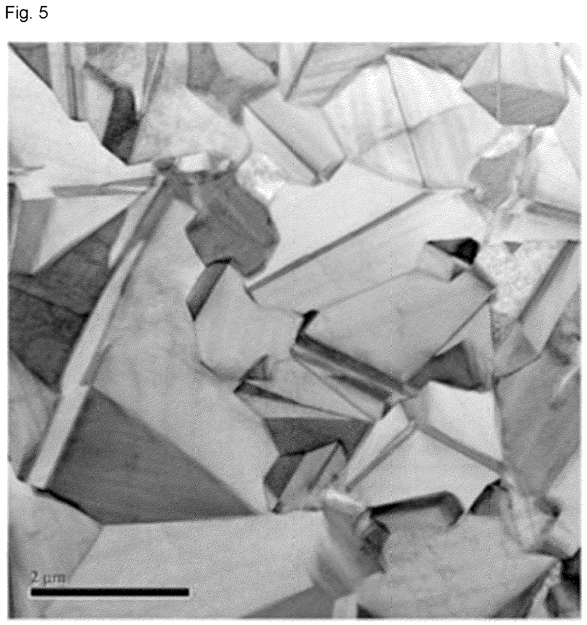

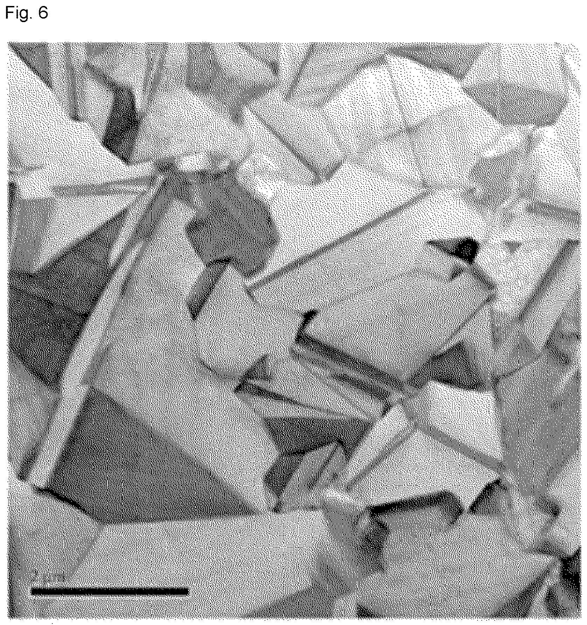

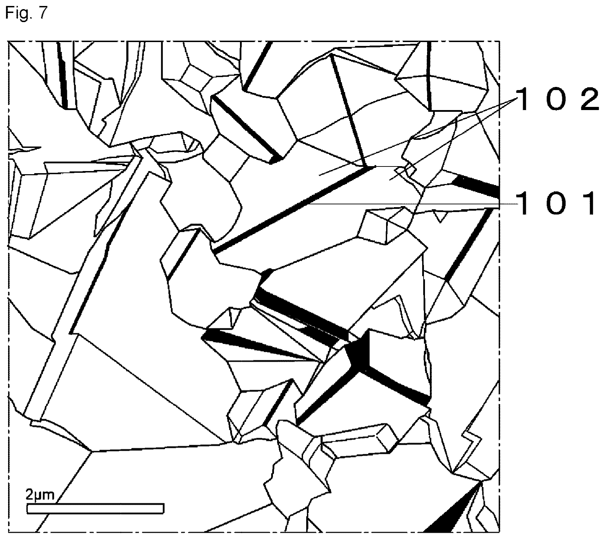

A plate-shaped region (101) and opposing regions (102) facing each other through this plate-shaped region (101) can be observed in Fig. 5, which is a STEM image of a cross-section parallel to the surface of the substrate, i.e., a horizontal cross-section, of the coating layer of the coated cutting tool in Fig. 1, Fig. 6, which is an image after dithering of Fig. 5, and Fig. 7, which is a line diagram of Fig. 5.

The aluminum content is measured with an electron probe microanalyzer, as described below. However, the STEAM images, Figs. 5, 6, and 7 demonstrate that the plate-shaped region (101) is darker than the opposing regions (102), and thus suggest that the plate-shaped region has a lower aluminum content than the opposing region.

The aforementioned issue can be solved by the presence of such columnar crystal grains. However, to ensure that this issue is solved, 20% or more, preferably 30% or more (100% is available) in number of the columnar crystal grains should have a diameter of a circle of 0.6 µm or more equal to their cross-sectional area (hereinafter referred to as "circular equivalent diameter") in the horizontal cross-section.

According to the method of manufacturing described as an embodiment below, the columnar crystal grains tend to be smaller near the substrate but larger near the surface of the coated cutting tool. It is presumed that the durability of the coated cutting tool is enhanced because these larger columnar grains themselves have higher strength. The aforementioned columnar grains with a plate-shaped region extending between the columnar grains facing each other through the plate-shaped region in a horizontal cross section are formed exclusively near the surface in the direction of the growth of the layer (near the surface of the AlCrCN layer). In other words, it is not necessary to refine the columnar crystals over the entire AlCrCN layer in this embodiment.

As the aluminum content of the coating layer increases, the difference in aluminum content increases between the opposing regions with a high aluminum content and the plate-shaped region with a low aluminum content. The difference in aluminum content between the opposing regions with a high aluminum content and the plate-shaped region with a low aluminum content is more preferably 10 atom% or more, even more preferably 20 atom% or more. It is more preferred that the aluminum content of the plate-shaped region be 30 to 80 atom% and the aluminum content of the opposing regions be 60 to 95 atom%.

It is more preferable that the crystal structure of the columnar grains in the plate-shaped region and the opposing region both have an fcc structure for an improvement in durability of the tool. The dispersion of AlN in the coating layer is allowed.

### (2) First and second layers inside columnar grains

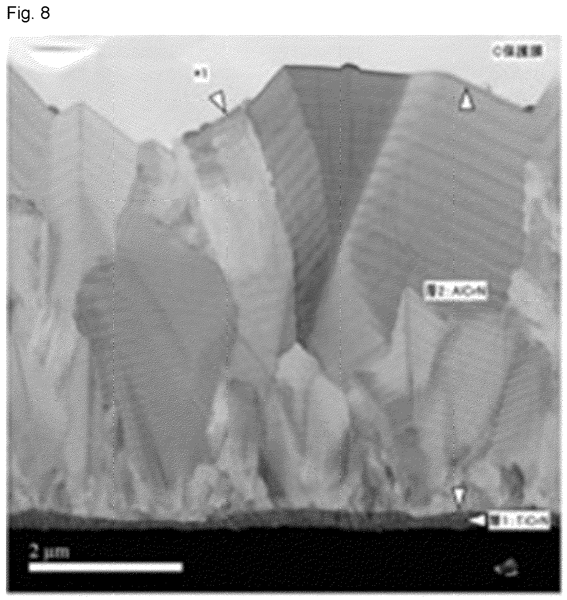

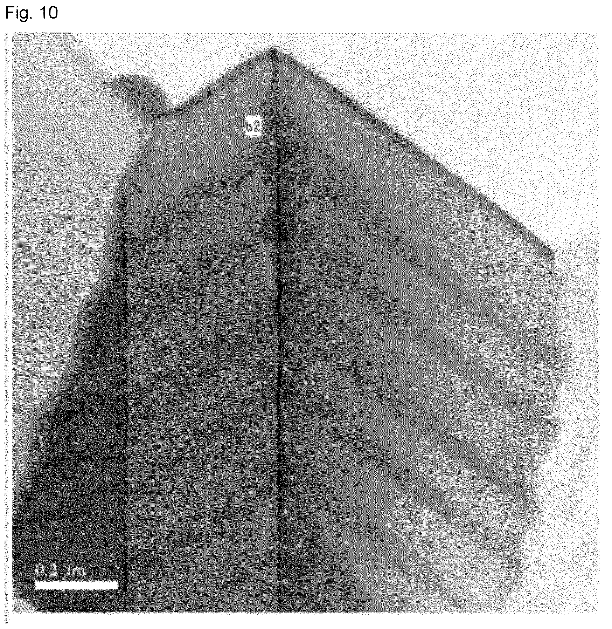

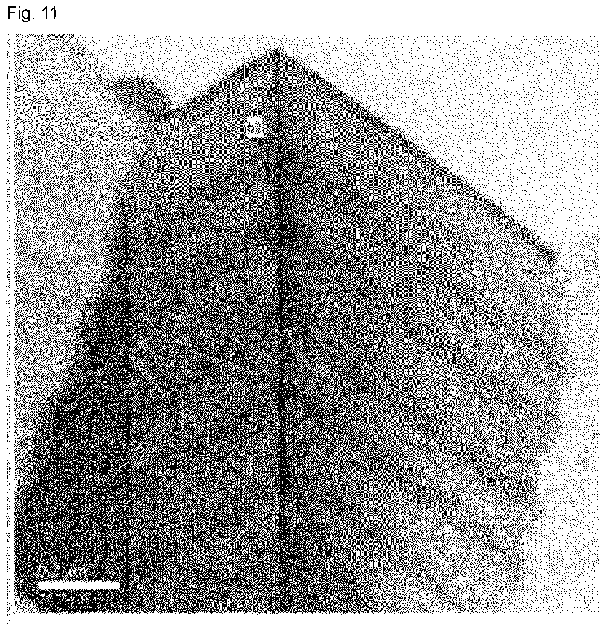

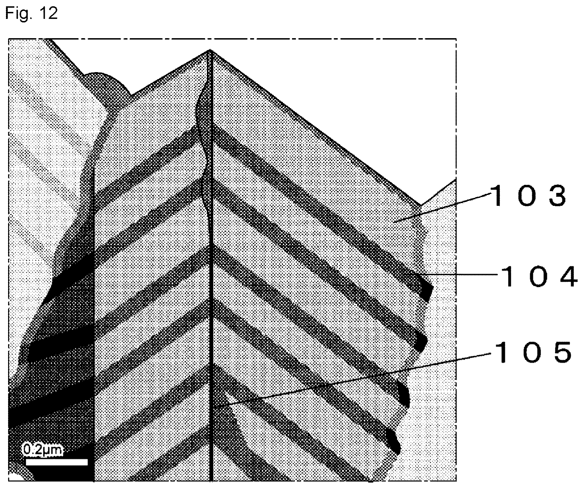

As shown in Figs. 8 through 12, which are examples of longitudinal sections of the coating layer, some of the columnar grains have first layers and second layers inside them. In other words, Fig. 10, which is a STEM image of a longitudinal section of the coating layer, Fig. 11, which is a dithered Fig. 10, and Fig. 12, which is a line diagram of Fig. 10, show that some of the columnar grains have first layers (103) and second layers (104). The Al-rich first layers (103) with a face-centered cubic structure and the Al-poor second layers (104) with a face-centered cubic structure are alternately stacked. Two stacks adjoin each other and are mirror-object via a boundary of the twinned plane (105).

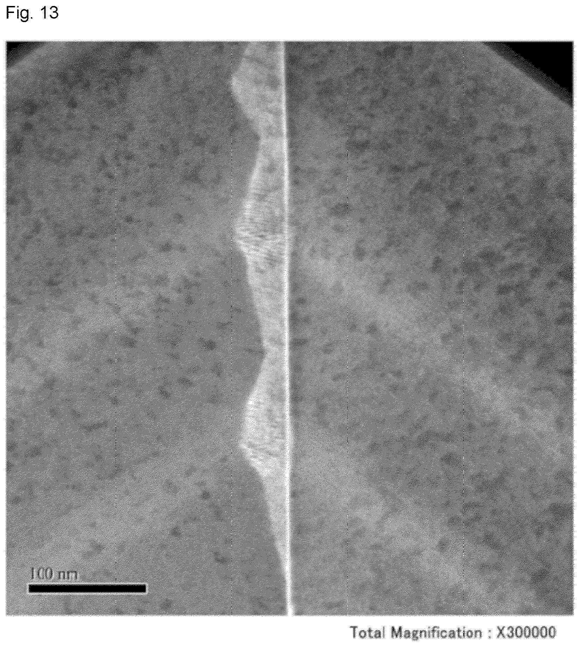

As described above, the aluminum content is measured with an electron probe microanalyzer (details will be described below). Figs. 10, 11, and 12, which are STEM images, however can infer that the aluminum content of the first layers (103) is higher than that of the second layers (104) because the first layers (103) are brighter than the second layers (104). It should be noted that the dark-field STEM images of Figs. 13, 14, and 15 are the opposite of the STEM images of Figs. 10, 11, and 12 in terms of light and dark.

As mentioned above, columnar particles tend to be smaller near the substrate but larger near the surface of the coated cutting tool. Since these larger columnar grains themselves have high strength, the coated cutting tool also is presumed to have higher strength. It should be noted that columnar grains where the adjacent first and second layers are in contact with each other at the twinned plane are formed near the surface in the direction of growth of the layer (near the surface of the coated layer). In other words, it is not necessary to refine the columnar crystal grains over the entire coating layer in this embodiment.

The difference in aluminum content between the first layers with high aluminum content and the second layers with low aluminum content should be at least 5 atom%. The aluminum content of the first layers should preferably be 50 to 95 atom% and the aluminum content of the second layers should preferably be 30 to 90 atom%. The twin plane tends to have a higher Cr content than the first and second layers.

The first and second layers each should preferably have a thickness of 1 nm to 200 nm. The first and second layers each should more preferably have a thickness of 10 nm to 200 nm. The first and second layers each should most preferably have a thickness of 20 nm to 150 nm. The first layers should preferably be thicker than the second layers.

The coating layer in the embodiment should preferably have a maximum intensity at one of the diffraction lines corresponding to the (111), (200), and (220) planes of the face-centered cubic structure by X-ray diffractometry.

### 3. Average thickness of coating layer

The coating layer, which does not include the lower layer, upper layer, and topmost surface layer described below, should preferably have an average thickness in a range of 2.0 µm to 10.0 µm for the following reasons: An average thickness of less than 2.0 µm is too small to ensure a sufficient tool life, while an average thickness of more than 10.0 µm may be too large to maintain the cutting accuracy. An average thickness is more preferably in a range of 4.0 µm to 9.0 µm, most preferably in a range of 5.0 µm to 8.0 µm.

### 4. Other layers

Although the aforementioned AlCrCN layer alone can solve the aforementioned problem, a lower, upper, and/or topmost surface layer described below may be optionally disposed. Layers that occur incidentally may also be produced.

### (1) Lower layer

The lower layer may be disposed to improve the adhesion of the AlCrCN layer to the substrate. The lower layer may comprise at least one layer selected from the group consisting of Ti compound layers composed of carbide, nitride, carbonitride, and carbonitroxide of Ti (not limited to stoichiometric composition), Cr compound layers composed of carbide, nitride, carbonitride, and carbonitroxide of Cr (not limited to stoichiometric composition), Ti and Cr compound nitride layers (not limited to stoichiometric composition), Ti and Al compound nitride layers (not limited to stoichiometric composition), and Ti and Al and Cr compound nitride layers (not limited to stoichiometric composition). The lower layer has a total average thickness of 0.1 to 20.0 µm, for example.

### (2) Upper layer

The upper layer may be disposed to further improve the durability of the tool. The upper layer is composed of aluminum oxide (not limited to stoichiometric composition) and has an average thickness of 1.0 to 25.0 µm, for example.

Alternatively, the upper layer may be composed of AlTiN or AlCrN with a composition different from that of the coating layer. The upper layer may consist of multiple sublayers having different compositions.

### (3) Topmost layer

A TiN (not limited to stoichiometric composition) topmost layer may also be disposed for the following reasons: TiN has a golden color tone and can be used as an indicator layer to determine, for example, whether the coated cutting tool is unused or used by a change in color tone on the surface of the coated cutting tool. The TiN indicator layer has a thickness of, for example, 0.1 to 1.0 µm.

### (4) Layers that may occur accidentally

In this embodiment, the deposition process is controlled such that no layers are formed other than the lower layer, AlCrCN layer, upper layer, and topmost surface layer. During switching of the type of layers to be deposited, however, unintentional fluctuations in pressure and temperature in the deposition system leads to a layer with a different composition from these layers to be unintentionally or accidentally formed between these layers. Such a layer is referred to as a layer that may accidentally occur.

### 5. Substrate

### (1) Material

The substrate used in the embodiment may be composed of any suitable material that can achieve the aforementioned purpose. Examples of such material include cemented carbides (WC-based cemented carbides, those containing Co in addition to WC, and also those containing carbides such as Ti, Ta, and Nb), Cermets (TiC, TiN, and TiCN as main components), ceramics (titanium carbide, silicon carbide, silicon nitride, aluminum nitride, aluminum oxide)), cBN sinters, or diamond sinters.

### (2) Shape

The substrate may have any shape suitable for cutting tools, for example, inserts, end mills, and drills.

### 6. Measurement of composition and average thickness

A longitudinal section (a plane perpendicular to the surface of the substrate, assuming that no microscopic irregularities are present on the surface of the substrate) of the tool is milled with a focused ion beam (FIB) system. The thicknesses are measured at five sites for all the layers at a magnification suitable for observation of, for example, 5,000 to 10,000 with a scanning electron microscope (SEM) or transmission electron microscope (TEM), and the observed values for each layer are averaged. Furthermore, the compositions at the five sites are measured by energy dispersive X-ray analysis (EDS) using SEM or TEM, Auger electron spectroscopy (AES) or with an electron probe microanalyzer (EPMA), based on the results of identification of each layer, and the average composition is calculated from the mean value. In addition, the crystal structure of each layer is identified from the restricted-field diffraction pattern.

The interface between the surface of the substrate and the coating layer is determined as follows:
For a substrate with a flat surface, for example, of an insert, the interface between the layer directly above the substrate and the substrate is determined based on elemental mapping measured with the aforementioned system on a longitudinal section, and the average line (straight line) of the roughness curve of the interface is determined arithmetically. This average line is defined as the surface of the substrate. For a substrate with a curved surface, for example, of a drill, the interface between the surface of the substrate and the coating layer can be regarded as virtually flat, because the diameter of the curved surface is sufficiently large in relation to the thickness of the coating layer. Thus, the interface between the surface of the substrate and the coating layer can be determined in the same way as the flat surface of the base material.

A horizontal section of the AlCrCN layer is prepared at a depth of about 0.5 µm from its surface, where the horizontal section is parallel to the surface of the substrate. The cross sections of any three or more columnar particles with a circular equivalent diameter of 0.6 µm or greater are subjected to measurement of the aluminum contents in the plate-shaped region and the opposing regions by EPMA, and the average value is determined.

### 7. Production

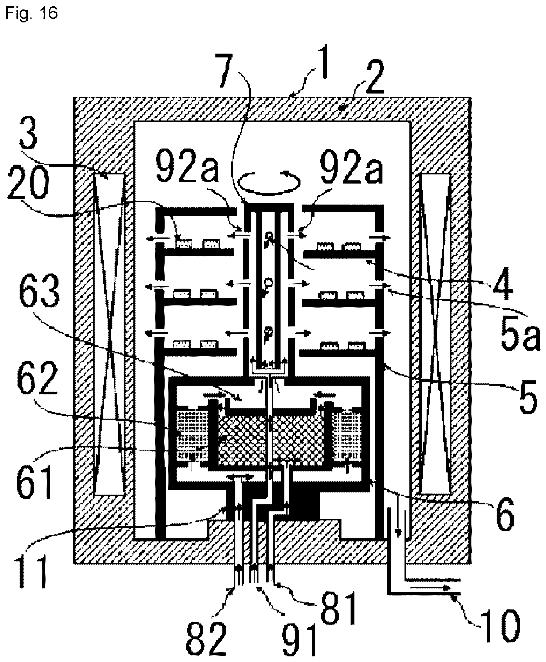

The coating layer of the coated cutting tool of this embodiment can be produced, for example, with a chemical vapor deposition furnace described in Japanese Patent No. 6660608 (see Fig. 16).

The mixed gas A used in the furnace of the deposition system is preferably prepared by adjusting the mixing ratio of two reaction gases (mixed gas a1 and mixed gas a2) such that the ratio of AlCl₃ to H₂ is increased with less H₂.

The lower layer, upper layer, and top surface layer can be deposited by any known process.

The description above is supported by the following appendices:
(Appendix 1) A coated cutting tool comprising a substrate and a coating layer on a surface of the substrate, wherein
   the coating layer comprises columnar crystal grains of composite nitride or carbonitride of aluminum and chromium made by chemical vapor deposition;
   the columnar crystal grains have a plate-shaped region extending through the columnar crystal grains and opposing regions on two sides of the plate-shaped region, in a cross-section parallel to the surface of the substrate, and
   the plate-shaped region has an aluminum content less than the aluminum content of the opposing regions on the two sides of the plate-shaped region.
(Appendix 2) The coated cutting tool described in Appendix 1, wherein the difference in the aluminum content between the plate-shaped region and the opposing regions on the two sides of the plate-shaped region is at least 10 atom%.
(Appendix 3) The coated cutting tool described in Appendix 2, wherein the aluminum content of the plate-shaped region is in a range of 30 to 80 atom% and the aluminum content of the opposing regions opposite on the two sides of the plate-shaped region is in a range of 60 to 95 atom%.
(Appendix 4) The coated cutting tool described in Appendix 1 to 3, wherein the columnar crystal grains have a fcc crystal structure both in the plate-shaped region and in the opposing regions opposite on the two sides of the plate-shaped region.
(Appendix 5) The coated cutting tool described in any one of Appendices 1 to 4, wherein the columnar particles having an equivalent circle diameter of 0.6 µm or more in a horizontal cross-section occupy at least 20% in number.
(Appendix 6) The coated cutting tool described in any one of Appendices 1 to 5, wherein
   the coating layer has an average composition represented by AlₓCr₁₋ₓC_{y}N_{1-y} where 0.50 ≤ x ≤ 0.95 and 0.0 ≤ y ≤ 0.4,
   the columnar crystal grains each comprise first layers and second layers therein and have a face-centered cubic lattice structure,
   the first layers and second layers are alternately stacked, and the first and second layers of one columnar crystal grain are in contact with the first and second layers of another columnar crystal grain at a specific angle via a twinned plane, and
   the first layers each have an aluminum content higher than that of the second layers.
(Appendix 7) The coated cutting tool described in Appendix 6, wherein The aluminum content of the first layers is in a range of 50 to 95 atom%, the aluminum content of the second layers is in a range of 30 to 95 atom%, and the difference in Aluminum content between these layers is at least 5 atom%.
(Appendix 8) The coated cutting tool described in Appendix 6 or 7, wherein the first layers and the second layers each have a thickness in a range of 1 to 200 nm. Examples

Examples will now be described. The present invention should not be limited to the examples.

Milling inserts were prepared that included substrates made of WC-based cemented carbide (composition: 10 mass% Co, 0.6 mass% Cr₃C₂, the balance WC and incidental impurities).

The deposition system used was a chemical vapor deposition (CVD) furnace as described in Japanese Patent No. 6660608.

The substrates were placed on an insert holder of a reaction chamber in the CVD furnace, and the temperature in the CVD furnace was increased to 800°C under a stream of H₂ gas. Gas containing titanium, chromium, and nitrogen was introduced at 800°C and 12 kPa to form 0.5 µm thick nitride of TiCr as a lower layer.

In the next stage, the substrates were each coated with nitride of AlCr.

After the pressure in the CVD furnace was reduced to 4 kPa under a stream of H₂ gas, a mixture of H₂ gas and HCl gas kept at 400°C was introduced into a gas pathway (82 in Fig. 16) of a preheating chamber (6 in Fig. 16).

The chromium chloride gas generating chamber (62 in Fig. 16) of the preheating chamber preheated to 800°C was filled with Cr metal flakes (99.99% purity, 2 mm to 8 mm in size), which reacted with a mixture of H₂ gas and HCl gas introduced through the gas pathway, resulting in generation of a mixed gas a1 of H₂ gas and chromium chloride gas. The mixed gas a1 was generated into a mixing chamber (63 in Fig. 16).

Another mixed gas a2, which was a mixture of H₂ gas and AlCl₃ gas, was introduced into the preheating chamber (61 in Fig. 16) from the gas inlet of the preheating chamber through the gas pathway (81 in Fig. 16). The mixed gas a1 and the mixed gas a2 were mixed in the mixing chamber to form a mixed gas A, which had a temperature approximately 800°C of the preheating chamber. The mixed gas A was then introduced into the reaction furnace through a first nozzle hole in a pipe. A mixed gas B consisting of H₂ gas, N₂ gas and NH₃ gas was also introduced into the gas pathway (91 in Fig. 16) and introduced into the furnace through the second nozzle hole of the pipe to coat the AlCrN layer. Table 1 shows the composition of the mixed gas A and mixed gas B.

**Table 1**

| Deposition temp. (°C) | Pressure (kPa) | Gas composition (Volume %) | | | | | | |
|---|---|---|---|---|---|---|---|---|
| | | Gas mixture A | | | | Gas mixture B | | |
| | | H₂ | N₂ | CrCl₃ | AlCl₃ | H₂ | N₂ | NH₃ |
| 800 | 4 | 54.4 | 6.33 | 0.84 | 0.15 | 12.65 | 25.3 | 0.32 |

The average thickness of the nitride layer of AlCr layer of Example 1 was determined according to the method described above to be 5.0 µm. The composition of the nitride layer of AlCr layer in Example 1 was determined at five points arbitrarily selected at approximately half the thickness of the nitride of AlCr in the longitudinal section, with an electron probe microanalyzer (EPMA, JEOL Ltd. JXA-8500F) at an acceleration voltage of 10 KV, an irradiation current of 0.05 A, and a beam diameter of 1 µm. The results were averaged into an average composition. The average composition of the nitride of AlCr in Example 1 was nitride of Al_{0.80}Cr_{0.20} (in atomic ratio).

Fig. 1 illustrates a photograph of a longitudinal section of the coating layer of Example 1 at a magnification of 5,000 by transmission electron microscopy. Fig. 2 is a dithered photograph of Fig. 1 as described above. In these photographs, large columnar crystal grains are observed on the surface side of the coating layer. The shading in the photograph demonstrates that plate-shaped regions, i.e., first layers and second layers with different compositions, are present within the columnar crystal grains.

Fig. 3 shows a photograph at a magnification of 20,000 by scanning electron microscopy of the surface of the coating layer of Example 1. Fig. 4 is a dithered photograph of Fig. 3, as described above. The observation of the surface of the coating layer elucidates that coarse columnar crystal grains are formed.

The longitudinal section of the columnar crystal grains was observed.

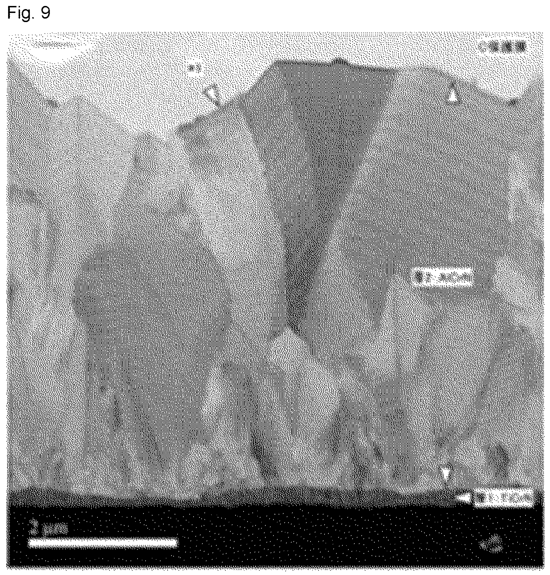

Fig. 5 is a longitudinal view STEM image of the coating layer at a magnification of 20,000, and Fig. 6 is a dithered version of Fig. 5. Fig. 8 is a cross-sectional view STEM image at a magnification of 20,000 of the coating layer in the direction of the growth of the layer near the surface, and Fig. 9 is a dithered version of Fig. 8. Fig. 10 is a cross-sectional view STEM image at a magnification of 100,000 of columnar crystal grains with twinned interfaces, Fig. 11 is a dithered version of Fig. 10, and Fig. 12 is a line diagram of Fig. 10.

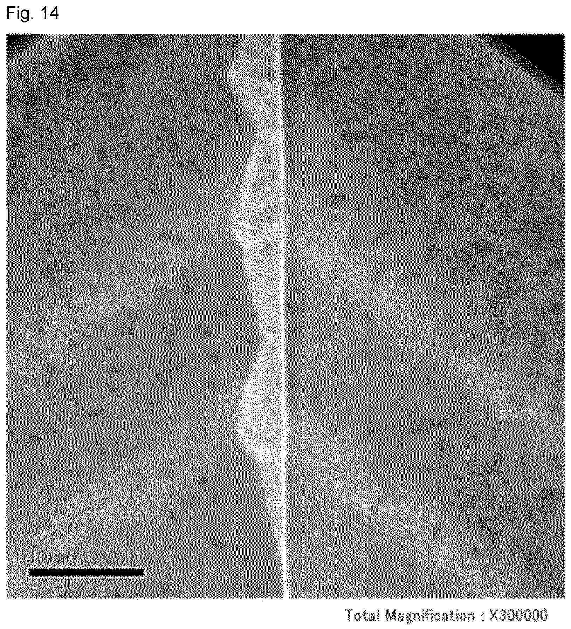

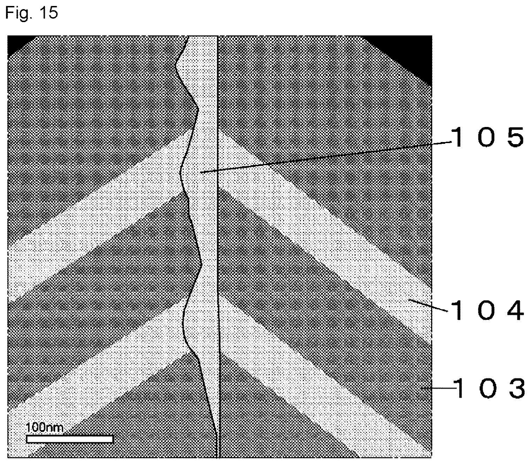

Figs. 10, 11, and 12 demonstrates that the coating layer of Example 1 has columnar crystal grains with a twin crystal interface (105). The columnar crystal grains have alternating layers of Al-rich first layers and Al-poor second layers. The first layers (Al-rich layers: 103) contain 90 atom% Al, while the second layers (Al-poor layers: 104) contain 85 atom% Al. The twin crystal plane (105) has a face-centered cubic structure containing about 55 atom% Al. In addition, a slight amount of AIN (hcp structure) is dispersed in the structure of the coating layer. With reference to Fig. 13, Fig. 14, which is a dithered version of Fig. 13, and Fig. 15, which is a line diagram of Fig. 13, areas having different shadings of black and white can be observed at the twin crystal interface, which means that both the first and second layers have areas of different shadings of black and white at the twin crystal interface.

The horizontal cross section of the columnar crystal grains was observed.

Fig. 5 is a photograph of a STEM image at magnification of 20,000 of the horizontal cross section on the surface of the substrate of the coating layer. Fig. 5 is a cross-sectional view STEM image of the coating layer in the direction of growth of the layer near the surface. As is clear from Fig. 5, Fig. 6, which is a dithered version of Fig. 5, and Fig. 7, which is a line diagram of Fig. 5, columnar crystal grains are observed that have a cross-sectional area of 0.6 µm or greater in circular equivalent diameter. A plate-shaped region (101) extending through the columnar crystal grains and opposing regions (102) can be observed. The distribution of the aluminum content within the cross section of the columnar crystal grains was measured with the EPMA described above under the same conditions as for the longitudinal section. The results are shown in Table 2.

The number of columnar crystal grains with a cross-sectional area of 0.6 µm or greater in circular equivalent diameter with an area opposite to the plate-shaped region in the horizontal cross section observed was more than 20% of the total.

In contrast, Comparative Example 1 is a milling insert with the same shape as Example 1, with a coating layer of AlTiN (aluminum content: 70 atom%) of approximately 5 µm (commercially available) produced by chemical vapor deposition. As shown in Table 2, in Comparative Example 1, no columnar crystal grains with a plate-shaped region and an opposing regions in the horizontal cross section could be identified (noted as "-").

**[Table 2]**

| Type | Al content of plate-shaped region | Al content of opposing region 1 (Al:Cr) | Al content of opposing region 2 (Al:Cr) | Al content (average) of opposing regions (Al:Cr) |
|---|---|---|---|---|
| Example 1 | 5 8 : 4 2 | 8 9 : 1 1 | 8 7 : 1 3 | 8 8 : 1 2 |
| Comparative Example 1 | - | - | - | - |

In Table 2, the aluminum content is expressed as the ratio (expressed in %) of the number of Al atoms to Cr atoms. As can be seen from Table 2, the aluminum content is less in the plate region than in the region opposite through the plate region, and the difference in aluminum content is 30 atom%, which is more than 10 atom%.

Cutting tests were conducted to evaluate cutting performance.

To evaluate the tool life of the milling insert of Example 1, the milling insert of Example 1 was attached to an edge-replaceable rotary tool (A45E-4160R) with a set screw, and milling was performed under the following cutting conditions.

Milling was performed for Comparative Example 1 under the same cutting conditions as in Example 1.

### Cutting conditions

Workpiece material: S55C (250HB)
Processing: Milling
Shape of Insert: SEE42TN-C9
Cutting speed: 200 m/min
Feed per cutting edge: 0.2 mm/tooth
Depth of cut in axial direction: 2.0 mm
Depth of cut in radial direction: 35 mm
Cutting process: Dry cutting

The wear width of the flank surface of the coating layer was measured every 5 minutes by observation under an optical microscope at a magnification of 100. The time of the cutting process leading to the total cutting length when the maximum wear width of the clearance surface exceeded 0.30 mm was defined as the tool life. The results are shown in Table 3.

**[Table 3]**

| Type | Life of tool (min) |
|---|---|
| Example 1 | 110 |
| Comparative Example 1 | 60 |

Table 3 evidentially demonstrates that Example 1 has higher durability than Comparison 1.

The foregoing disclosed embodiments are in all respects illustrative only and are not restrictive. The scope of the present invention is indicated by the claims, not the aforementioned embodiments, and is intended to include all modifications within the meaning and scope of the claims and equivalents.

### Reference Numerals

- 1:: chemical vapor deposition (CVD) furnace
- 2:: chamber
- 3:: heater
- 4:: insert holder
- 5:: reaction vessel
- 5a:: opening of reaction vessel
- 6:: preheating chamber (preheating section)
- 61:: preheating chamber
- 62:: chromium chloride gas generation chamber
- 63:: mixing chamber
- 7:: pipe (gas release section)
- 101:: plate-shaped area
- 102:: opposing area
- 103:: first layer
- 104:: second layer
- 105:: twinned interface

## Claims

1. A coated cutting tool comprising a substrate and a coating layer on a surface of the substrate, wherein
the coating layer comprises columnar crystal grains of composite nitride or carbonitride of aluminum and chromium made by chemical vapor deposition;
the columnar crystal grains have a plate-shaped region extending through the columnar crystal grains and opposing regions on two sides of the plate-shaped region, in a cross-section parallel to the surface of the substrate, and
the plate-shaped region has an aluminum content less than the aluminum content of the opposing regions on the two sides of the plate-shaped region.

2. The coated cutting tool as claimed in claim 1, wherein the difference in the aluminum content between the plate-shaped region and the opposing regions on the two sides of the plate-shaped region is at least 10 atom%.

3. The coated cutting tool as claimed in claim 2, wherein the aluminum content of the plate-shaped region is in a range of 30 to 80 atom% and the aluminum content of the opposing regions opposite on the two sides of the plate-shaped region is in a range of 60 to 95 atom%.

4. The coated cutting tool as claimed in claim 3, wherein the columnar crystal grains have a fcc crystal structure both in the plate-shaped region and in the opposing regions opposite on the two sides of the plate-shaped region.

5. The coated cutting tool as claimed in claim 1, wherein
the coating layer has an average composition represented by AlₓCr₁₋ₓC_{y}N_{1-y} where 0.50 ≤ x ≤ 0.95 and 0.0 ≤ y ≤ 0.4,
the columnar crystal grains each comprise first layers and second layers therein and have a face-centered cubic lattice structure,
the first layers and second layers are alternately stacked, and the first and second layers of one columnar crystal grain are in contact with the first and second layers of another columnar crystal grain at a specific angle via a twinned plane, and
the first layers each have an aluminum content higher than that of the second layers.
